# FASCICULE DE BREVET EUROPEEN

(11) **EP 3 275 084 B1**
(45) Date de publication et mention de la délivrance du brevet: **01.05.2019**
(21) Numéro de dépôt: 16714800.6
(22) Date de dépôt: 23.03.2016
(51) Int. Cl.: H04B 3/56, H01F 38/14, H03H 7/01, H03H 7/09, H04B 3/54, H04L 25/02

(54) **COUPLEUR ÉLECTRIQUE PUISSANCE/DONNÉES**
STROM-/DATEN-ELEKTROVERBINDER
POWER/DATA ELECTRICAL COUPLER

(30) Priorité: 25.03.2015 FR 1552499
(43) Date de publication de la demande: 31.01.2018
(73) Titulaire: Safran Electronics & Defense SAS, 92100 Boulogne-Billancourt (FR)
(72) Inventeur: GUILLOT, François, 92100 Boulogne Billancourt (FR)
(74) Mandataire: Cabinet Le Guen Maillet
(86) Numéro de dépôt international: PCT/EP2016/056324
(87) Numéro de publication internationale: WO 2016/150989

(56) Documents cités:
- DE-A1-102008 007 023
- FR-A1- 2 993 106

## Description

La présente invention concerne un coupleur électrique puissance/données. Un tel coupleur électrique est prévu pour émettre sur un bus des signaux de données délivrés par un périphérique et recevoir des signaux de données dudit bus et les délivrer à un périphérique. Il est également prévu pour délivrer audit bus une tension alternative d'alimentation ou la recevoir dudit bus. Un tel coupleur puissance/données est par exemple utilisé pour coupler, via un bus, des actionneurs électriques à des unités de commande et à des alimentations de puissance en formant un réseau de transport de données et d'alimentation. De tels réseaux sont par exemple embarqués sur des aéronefs.

Divers modes de réalisation de tels coupleurs électriques puissance/données sont connus et on pourra se reporter, à titre d'exemples, à ceux qui sont décrits dans les publications de brevet DE102008007023 et FR2993106. Un autre mode de réalisation équivalent est décrit en relation avec la Fig. 1 afin de mieux présenter le problème que la présente invention cherche à résoudre.

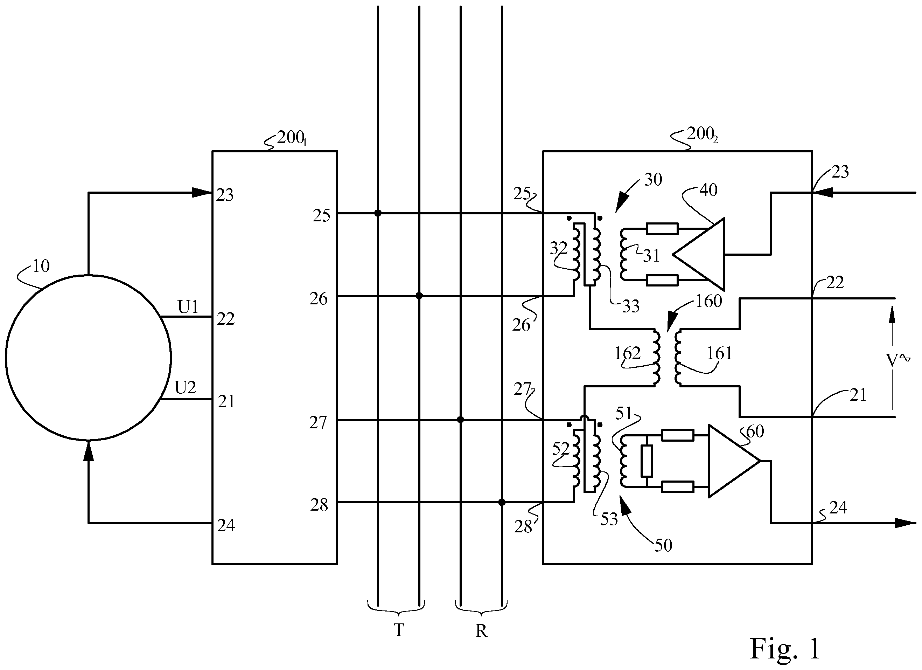

On a représenté à la Fig. 1 un tel réseau de transport de données et d'alimentation. Ce réseau comprend un actionneur 10 et deux coupleurs électriques puissance/données 200₁ et 200₂ selon l'état de la technique. L'actionneur 10 est relié au coupleur électrique 200₁, d'une part, pour y être alimenté en puissance par des plots d'alimentation 21 et 22 du coupleur électrique 200₁ et, d'autre part, pour émettre des données sur le réseau via le plot 23, ou pour recevoir des données du réseau via le plot 24. De même, le coupleur électrique 200₂ comporte des plots d'alimentation 21 et 22 destinés à être reliés soit aux bornes d'alimentation d'un autre actionneur (non représenté), soit aux bornes d'une source d'alimentation (non représentée). Il comporte encore des plots 23 et 24 pour respectivement recevoir et émettre des données, par exemple d'un périphérique tel qu'un actionneur ou une unité de commande, telle qu'un ordinateur. Les coupleurs électriques 200₁ et 200₂ sont reliés, via des plots respectifs 25, 26, 27 et 28 à un bus B constitué de deux paires de fils T et R pour, d'une part, le transport respectifs des données qui sont émises par un périphérique et des données qui sont à destination d'autres périphériques et, d'autre part, la circulation du courant d'alimentation délivré par la ou les sources d'alimentation connectées au réseau et fourni aux actionneurs connectés au réseau. D'autres coupleurs électriques que ceux représentés peuvent être connectés au bus B pour d'autres actionneurs ou périphériques. Comme on le verra par la suite, alors que les données sont transportées sur chacune des paires de fils T et R en mode différentiel, le courant d'alimentation est lui transporté en mode commun.

La structure du coupleur électrique 200₂ est détaillée. Cette structure est la même pour tous les coupleurs électriques du réseau. Il comporte un premier transformateur 30, dit transformateur d'émission, dont les bornes d'un enroulement 31 sont reliées, via des résistances d'adaptation d'impédances respectives, à deux sorties d'un amplificateur 40 recevant sur son entrée des signaux de données présents sur le plot 23. Cet enroulement 31 crée un flux magnétique qui excite deux autres enroulements identiques 32 et 33 du transformateur d'émission 30. Ces enroulements 32 et 33 sont reliés en série entre eux avec une borne commune et deux autres bornes reliées aux plots 25 et 26 et ainsi à la paire de fils T du bus B. Ils sont enroulés de manière qu'ils reçoivent le même flux magnétique de l'enroulement 31 et délivrent le même signal à leurs propres bornes (voir la représentation à cet effet par deux points symboliques).

Le coupleur électrique 200₂ comporte encore un second transformateur 50, dit transformateur de réception, dont deux enroulements identiques 52 et 53 sont reliés en série entre eux avec une borne commune et deux autres bornes reliées aux plots 27 et 28 et ainsi à la paire de fils R du bus B. Il comporte un troisième enroulement 51 dont les bornes sont reliées, via des résistances d'adaptation d'impédances, aux entrées d'un amplificateur 60 dont la sortie est reliée au plot 24 du coupleur électrique 200₂ pour délivrer des données à un périphérique. Les enroulements 52 et 53 sont enroulés de manière que leurs flux magnétiques s'additionnent pour exciter l'enroulement 51 (voir les points symboliques à cet effet).

Il comprend encore un transformateur d'isolation galvanique 160 dont un enroulement 161 est relié aux plots d'alimentation 22 et 21 sur lesquels est connecté soit un périphérique pour y être alimenté, soit une source d'alimentation de tension alternative V. Quant à l'enroulement 162 du transformateur 160, il a une borne qui est reliée à la borne commune des enroulements 32 et 33 du transformateur d'émission 30 et l'autre borne qui est reliée à la borne commune des enroulements 52 et 53 du transformateur de réception 50.

On notera que le transformateur d'isolation galvanique 160 pourrait ne pas être inclus au coupleur électrique 200₂ comme cela est représenté à la Fig. 1 mais au contraire être monté à distance de ce coupleur électrique 200₂.

Lorsqu'une source d'alimentation est connectée aux plots d'alimentation 21 et 22, la tension qu'elle délivre se retrouve aux bornes de l'enroulement 161 du transformateur d'isolation galvanique 160, puis, à un facteur de transformation près du transformateur 160 (généralement égal à 1), aux bornes de son enroulement 162. Ainsi, le potentiel d'une des bornes de l'enroulement 162 se retrouve sur la borne commune des enroulements 32 et 33 du transformateur d'émission 30 et donc sur chacun des fils de la paire de fils T du bus B alors que le potentiel de l'autre borne de l'enroulement 162 se retrouve sur la borne commune des enroulements 52 et 53 du transformateur de réception 50 et donc sur chacun des fils de la paire de fils R du bus B. A l'inverse, lorsqu'un actionneur est connecté aux plots d'alimentation 21 et 22 pour y être alimenté, le potentiel présent sur chacun des fils de la paire T se retrouve au point commun des enroulements 32 et 33 et donc sur une première borne de l'enroulement 162 alors que le potentiel présent sur chacun des fils de la paire R se retrouve au point commun des enroulements 52 et 53 et donc sur l'autre borne de l'enroulement 162 du transformateur 160. Il en résulte une tension d'alimentation aux bornes de l'enroulement 161 du transformateur 160 et donc sur les plots d'alimentation 21 et 22. Il s'agit ici du mode commun.

Les signaux de données présents sur le plot 23, après amplification par l'amplificateur 40, excitent l'enroulement 31 du transformateur d'émission 30, lequel génère un flux magnétique qui est capté par les enroulements 32 et 33, lesquels génèrent, sur les fils respectifs de la paire de fils T du bus B, des signaux de données d'amplitudes opposées. De même, les signaux de données d'amplitudes opposées respectivement présents sur les fils de la paire de fils R du bus B se retrouvent aux bornes des enroulements 52 et 53 du transformateur de réception 30, ce qui génère des flux magnétiques excitant alors l'enroulement 51 qui engendre alors un signal de données qui, après amplification est fourni au plot 24 à destination d'un périphérique. Il s'agit alors du mode différentiel.

Ainsi, les données sont transportées sur chacune des paires de fils T et R en mode différentiel alors que le courant d'alimentation, dans un sens ou l'autre, est lui transporté en mode commun.

La tension d'alimentation est alternative de relativement faible fréquence (par exemple inférieure à 1 MHz) comparée à la fréquence de transmission des données (par exemple quelques centaines de MHz, pour une transmission de type Ethernet).

Cette structure particulière d'un coupleur électrique, tel que les coupleurs électriques 200₁ et 200₂ de la Fig. 1, peut poser des problèmes lorsque des courants parasites circulent sur les paires de fils T ou R. Cela peut notamment être le cas en présence de foudre ou lors de tests haute fréquence tels que ceux qui sont recommandés par la norme DO-160. Ces courants parasites, généralement transmis en mode commun dans les enroulements 32 et 33 du transformateur d'émission 30 et les enroulements 52 et 53 du transformateur de réception 30, se retrouvent aux bornes de l'enroulement 162 du transformateur d'isolation galvanique 160, et donc aux bornes de son enroulement 161 et aussi sur les plots d'alimentation 21 et 22. Ils peuvent alors endommager les actionneurs ou les sources d'alimentation qui y sont branchés.

Le but de la présente invention est de proposer un coupleur électrique tel que celui qui vient d'être décrit en relation avec la Fig. 1 mais qui soit d'une structure telle qu'elle permette de résoudre les problèmes évoqués ci-dessus.

Pour ce faire, la présente invention concerne un coupleur électrique puissance/données qui comporte :
- un transformateur d'émission constitué d'un enroulement pour recevoir des signaux de données et de deux enroulements reliés en série entre eux avec un point commun et deux bornes destinées à être reliées à une première paire de fils T d'un bus afin de délivrer à ladite paire de fils, en mode différentiel, les signaux de données présents aux bornes du premier enroulement, et
- un transformateur de réception constitué de deux enroulements reliés en série entre eux avec un point commun et deux bornes destinées à être reliées à une seconde paire de fils R dudit bus pour recevoir, en mode différentiel, des signaux de données présents sur la paire de fils du bus et un enroulement pour délivrer lesdits signaux de données.

Il comporte de plus un transformateur d'isolation galvanique qui lui-même comporte un premier enroulement dont les bornes sont reliées aux plots d'alimentation dudit coupleur et un second et troisième enroulements reliés en série entre eux avec un point commun relié à une masse mécanique et les bornes libres respectives reliées à la borne commune des enroulements du transformateur d'émission et à la borne commune des enroulements du transformateur de réception.

Selon une autre caractéristique avantageuse de la présente invention, ledit coupleur comporte en outre un transformateur d'isolement constitué de deux enroulements identiques couplés magnétiquement, dont les bornes d'entrée sont respectivement reliées aux bornes de l'enroulement du transformateur d'isolation galvanique et dont les bornes de sortie sont respectivement reliées aux plots d'alimentation dudit coupleur électrique.

Selon une autre caractéristique avantageuse de la présente invention, ledit coupleur comporte des capacités respectivement reliées en parallèle aux bornes des enroulements dudit transformateur d'isolement formant, avec lesdits enroulements, des filtres réjecteurs à une fréquence correspondant à la ou une fréquence de résonnance des transformateurs d'émission et réception.

Selon une autre caractéristique avantageuse de la présente invention, le transformateur d'émission comporte un quatrième enroulement dont les bornes sont respectivement reliées aux premières bornes de deux enroulements identiques dont les secondes bornes sont reliées à une masse mécanique, et le transformateur de réception comporte un quatrième enroulement dont les bornes sont respectivement reliées aux premières bornes de deux enroulements identiques dont les secondes bornes sont reliées à la masse mécanique.

Selon une autre caractéristique avantageuse de la présente invention, ledit coupleur comporte un transformateur d'isolement constitué de deux enroulements identiques couplés magnétiquement, dont les bornes d'entrée sont destinées à être reliées à la paire de fils T et dont les bornes de sortie sont respectivement reliées aux bornes des enroulements du transformateur d'émission et un transformateur d'isolement constitué de deux enroulements identiques couplés magnétiquement, dont les bornes d'entrée sont destinées à être reliées à la paire de fils R et dont les bornes de sortie sont respectivement reliées aux bornes des enroulements du transformateur de réception.

La présente invention concerne également un réseau de transport de données et d'alimentation prévu pour coupler, via un bus constitué de deux paires de fils T et R, des actionneurs électriques à des périphériques et à des alimentations de puissance, qui est caractérisé en ce qu'il comporte au moins deux coupleurs électriques tels qu'ils viennent d'être décrits.

Les caractéristiques de l'invention mentionnées ci-dessous, ainsi que d'autres, apparaîtront plus clairement à la lecture de la description suivante d'exemples de réalisation, ladite description étant faite en relation avec les dessins joints, parmi lesquels :
La Fig. 1 est un schéma synoptique d'un réseau de transport de données et d'alimentation qui incorpore un coupleur électrique de l'état de la technique,
La Fig. 2 est un schéma synoptique d'un coupleur électrique selon un premier mode de réalisation de la présente invention,
La Fig. 3 est un schéma synoptique d'un coupleur électrique selon un second mode de réalisation de la présente invention, et
La Fig. 4 est un schéma synoptique d'un coupleur électrique selon un troisième mode de réalisation de la présente invention.

Un coupleur électrique selon la présente invention est destiné à être implémenté de la même manière que les coupleurs électriques de l'état de la technique, tels les coupleurs 200₁ et 200₂ qui ont été représentés à la Fig. 1.

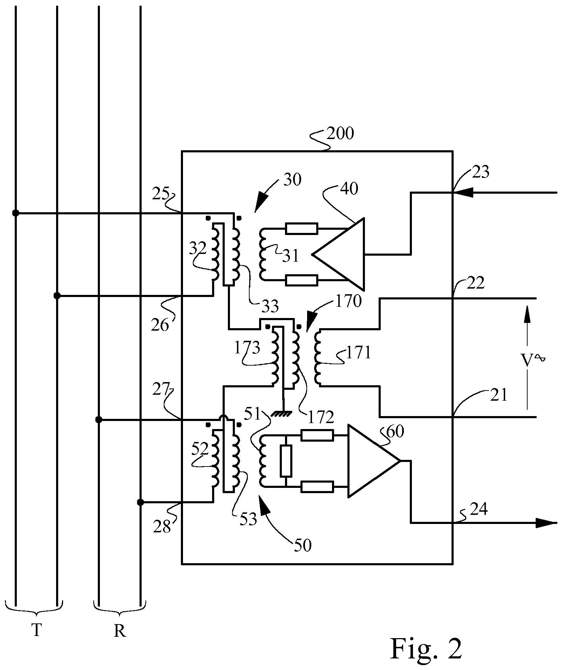

A la Fig. 2, on a donc représenté un coupleur électrique 200 selon le premier mode de réalisation de la présente invention. Comme on peut le constater, ce coupleur électrique 200 comporte les mêmes plots que les coupleurs électriques 200₁ et 200₂ de la Fig. 1, en particulier des plots 25 et 26 pour l'émission de données vers une paire de fils T d'un bus B d'un réseau, des plots 27 et 28 pour la réception de données d'une paire de fils R du bus B, des plots d'alimentation 21 et 22 pour, selon l'utilisation faite du coupleur électrique, la connexion soit d'une source d'alimentation délivrant une tension d'alimentation alternative, soit d'un périphérique pour y être alimenté, et des plots 23 et 24 pour respectivement recevoir des données émises par un périphérique tel qu'un actionneur ou une unité de commande ou pour émettre des données à destination d'un tel périphérique.

Comme on peut le constater, le coupleur électrique 200 comporte des éléments qui sont déjà présents dans le coupleur électrique 200₂ de la Fig. 1. Ces mêmes éléments portent donc la même référence qu'à la Fig. 1 et ne sont pas ici de nouveau décrits.

Le coupleur électrique 200 diffère de celui qui est décrit en relation avec la Fig. 1 en ce qu'il comporte, en lieu et place du transformateur d'isolation galvanique 160 de l'état de la technique, un transformateur d'isolation galvanique 170 comportant un premier enroulement 171 dont les bornes sont reliées aux plots d'alimentation 21 et 22 et un second et un troisième enroulements 172 et 173 reliés en série entre eux avec une borne commune reliée à une masse mécanique (par exemple, la masse mécanique de l'appareil dans lequel est installé le réseau) et les autres bornes respectives reliées à la borne commune des enroulements 32 et 33 du transformateur d'émission 30 et à la borne commune des enroulements 52 et 53 du transformateur de réception 50. Les enroulements 172 et 173 sont couplés magnétiquement à l'enroulement 171. Par ailleurs, ils sont enroulés de manière qu'ils reçoivent le même flux magnétique de l'enroulement 171 et délivrent le même signal à leurs propres bornes (voir la représentation à cet effet par des points symboliques).

Le fonctionnement est le suivant. La paire de fils T du bus B est portée à un potentiel alternatif qui est aiguillé, en mode commun dans le transformateur d'émission 30, sur la borne libre du second enroulement 172 du transformateur 170. La paire de fils R du bus B est quant à elle portée à un autre potentiel alternatif qui lui aussi est aiguillé, en mode commun dans le transformateur de réception 50, sur la borne libre du troisième enroulement 173 du transformateur 170. Ces potentiels étant différents, le transformateur 170 fonctionne en mode différentiel si bien que la différence de potentiel aux bornes libres des enroulements 172 et 173 se retrouve, au facteur de transformation près du transformateur 170 (généralement égal à 1), aux bornes de l'enroulement 171 et donc sur les plots d'alimentation 21 et 22, développant une tension d'alimentation V.

Les courants parasites qui seraient présents sur les fils des paires de fils T et R du bus B, par exemple engendrés par la foudre ou injectés lors de tests haute fréquence ou autres, du fait qu'ils ont sensiblement la même amplitude sur chacun des fils du bus B, sont aiguillés en mode commun par les enroulements 32 et 33 du transformateur d'émission 30, d'une part, et par les enroulements 52 et 53 du transformateur de réception 50, d'autre part, vers les bornes des enroulements 172 et 173 du transformateur 170. Etant de plus, d'amplitudes égales sur ces bornes, d'une part, ils sont aiguillés en mode commun sur la masse mécanique reliée au point commun de ces enroulements 172 et 173 et, d'autre part, sont sans effet en mode différentiel du transformateur 170 aux bornes de l'enroulement 171. Ainsi, tout périphérique connecté aux plots d'alimentation 21 et 22 est protégé de ces courants parasites.

En cas de foudre ou d'injection de signaux tests à haute fréquence, les signaux parasites en question peuvent être de haute fréquence. Les tensions impliquées peuvent alors être d'amplitude importante, notamment si les fréquences de ces signaux se trouvent dans une bande de fréquences incluant la fréquence ou une fréquence de résonnance des transformateurs d'émission et de réception 30 et 50. Ces signaux sur chacun des paires de fils R et T du bus B peuvent ne pas être d'amplitudes respectives rigoureusement égales. De ce fait, des résidus de ces signaux peuvent être transmis, en mode différentiel, à l'enroulement 171 du transformateur 170 et donc sur les plots d'alimentation 21 et 22 du coupleur 200, pouvant perturber l'appareil connecté à ces plots 21 et 22.

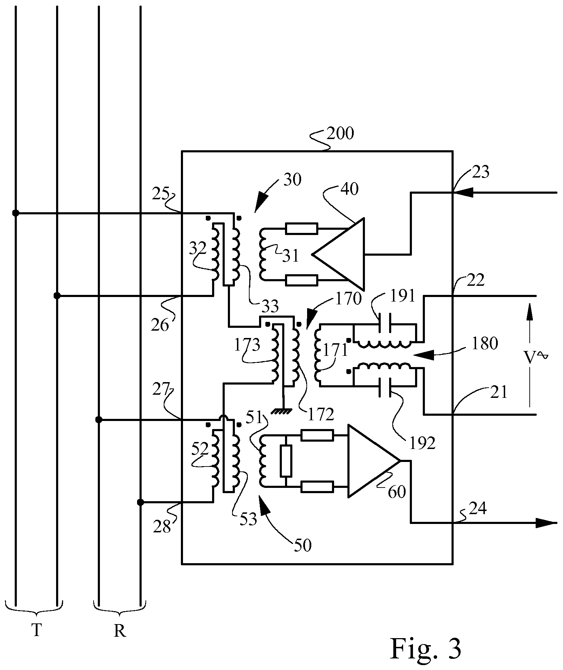

Le mode de réalisation d'un coupleur électrique 200 représenté à la Fig. 3 permet de résoudre ce problème. Il comporte un transformateur d'isolement 180 constitué de deux enroulements identiques 181 et 182 couplés magnétiquement, dont les bornes d'entrée (marquées par un point) sont respectivement reliées aux bornes de l'enroulement 171 du transformateur 170 et dont les bornes de sortie sont respectivement reliées aux plots d'alimentation 21 et 22. Les signaux transmis via ce transformateur d'isolement 180 en mode commun sont fortement atténués alors que les signaux transmis en mode différentiel ne le sont pas.

De plus, en parallèle sur chacun des enroulements 181, 182 du transformateur 180, sont montés des condensateurs 191 et 192 qui forment alors avec les enroulements respectifs 181 et 182 du transformateur 180 des filtres réjecteurs à une fréquence, selon l'invention, correspondant à la ou une fréquence de résonnance des transformateurs d'émission et réception 30 et 50.

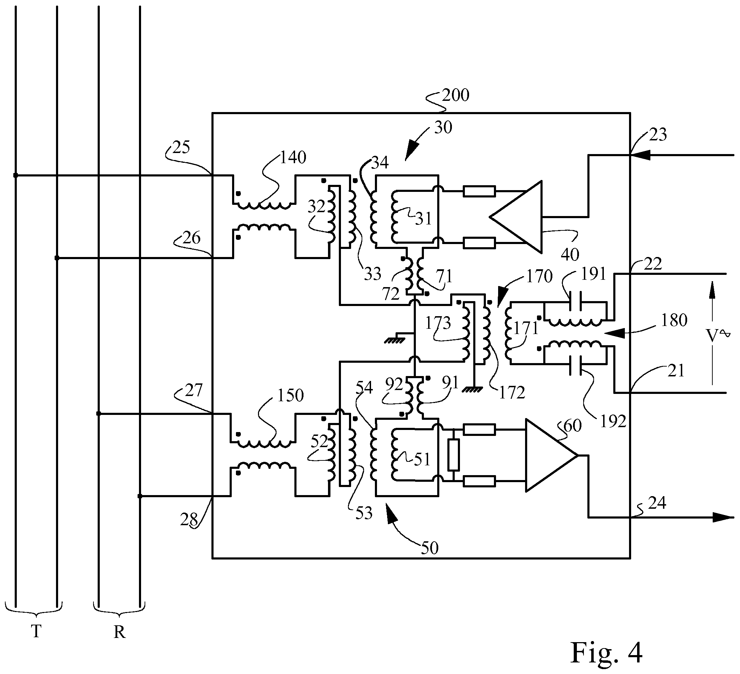

Le troisième mode de réalisation représenté à la Fig. 4 diffère du second mode de réalisation en ce que le transformateur d'émission 30 comporte maintenant un quatrième enroulement 34 dont les bornes sont respectivement reliées aux premières bornes de deux enroulements identiques 71 et 72 dont les secondes bornes sont reliées à la masse mécanique (par exemple, celle de l'appareil dans lequel est installé le réseau). Les enroulements 71 et 72 sont couplés magnétiquement et sont enroulés dans des sens différents (voir points symboliques liés à ces enroulements). De même, le transformateur de réception 50 comporte un quatrième enroulement 54 dont les bornes sont respectivement reliées aux premières bornes de deux enroulements identiques 91 et 92 dont les secondes bornes sont reliées à la masse mécanique (par exemple, celle de l'appareil dans lequel est installé le réseau). Les enroulements 91 et 92 sont couplés magnétiquement et sont enroulés dans des sens différents (voir points symboliques liés à ces enroulements).

L'enroulement 34 forme un écran capacitif entre l'enroulement 31, d'une part, et les enroulements 32 et 33, d'autre part, ce qui a pour effet d'augmenter substantiellement la fréquence de résonnance F0 liée aux capacités parasites du transformateur d'émission 30. Par ailleurs, parmi les courants haute fréquence qui seraient présents sur les fils de la paire de fils T, par exemple engendrés par la foudre ou injectés lors de tests haute fréquence, ceux qui présentent une fréquence de résonnance F0, sont d'amplitude élevée au niveau du transformateur d'émission 30. Ils excitent l'enroulement 34 qui les aiguillent alors vers la masse mécanique via les enroulements 71 et 72 qui, en mode commun, présentent une impédance faible. L'amplificateur 40 est ainsi protégé contre des surtensions pouvant apparaître aux bornes de l'enroulement 31 du transformateur d'émission 30. En dehors de ces fréquences, les enroulements 71 et 72 présentent une impédance élevée si bien que l'enroulement 34 ne forme plus écran. Le fonctionnement de l'amplificateur 40 n'est alors pas perturbé.

De même, l'enroulement 54 forme un écran capacitif entre l'enroulement 51, d'une part, et les enroulements 52 et 53, d'autre part, ce qui a pour effet d'augmenter substantiellement la fréquence de résonnance F0 liée aux capacités parasites du transformateur de réception 50. De plus, parmi les courants haute fréquence qui seraient présents sur les fils de la paire de fils R, par exemple engendrés par la foudre ou injectés lors de tests haute fréquence, ceux qui présentent une fréquence de résonnance F0 sont amplifiés par résonnance au niveau du transformateur de réception 50. Ils excitent l'enroulement 54 qui les aiguillent alors vers la masse mécanique via les enroulements 91 et 92 qui, en mode commun, présentent une impédance faible. En dehors de ces fréquences, les enroulements 91 et 92 présentent une impédance élevée si bien que l'enroulement 54 ne forme plus écran.

De plus, le coupleur électrique 200 qui est représenté à la Fig. 4 comporte, pour la voie correspondant à la paire de fils T du bus B, un transformateur d'isolement 140 constitué de deux enroulements identiques couplés magnétiquement, dont les bornes d'entrée (marquées par un point) sont reliées aux plots 25 et 26 du coupleur destinés à être reliés à la paire de fils T et dont les bornes de sortie sont respectivement reliées aux bornes des enroulements 32 et 33 du transformateur d'émission 30. Les signaux transmis via ce transformateur d'isolement 140 en mode commun, généralement des signaux parasites, sont fortement atténués alors que les signaux transmis en mode différentiel, ici les signaux de données, ne le sont pas. De même, pour la voie correspondant à la paire de fils R du bus, le coupleur électrique 200 de la Fig. 4 comporte un transformateur d'isolement 150 de structure et de fonctionnement identiques à ceux du transformateur d'isolement 140.

Les coupleurs électriques, objets des Figs. 2 à 4, sont prévus pour une alimentation en alternatif basse fréquence (par exemple inférieure à 1 MHz, c'est-à-dire inférieure de plusieurs ordres de grandeurs à la fréquence des signaux de données (par exemple supérieur à 100 MHz).

## Revendications

1. Coupleur électrique puissance/données (20T; 20R) comportant :
- un transformateur d'émission (30) constitué d'un enroulement (31) pour recevoir des signaux de données et de deux enroulements (32 et 33) reliés en série entre eux avec un point commun et deux bornes destinées à être reliées à une première paire de fils (T) d'un bus (B) afin de délivrer à ladite paire de fils (T), en mode différentiel, les signaux de données présents aux bornes du premier enroulement (31),
- un transformateur de réception (50) constitué de deux enroulements (52 et 53) reliés en série entre eux avec un point commun et deux bornes destinées à être reliées à une seconde paire de fils (R) dudit bus (B) pour recevoir, en mode différentiel, des signaux de données présents sur la paire de fils (R) du bus (B) et un enroulement (51) pour délivrer lesdits signaux de données, et
- un transformateur d'isolation galvanique,
**caractérisé en ce que** ledit transformateur d'isolation galvanique (170) comporte un premier enroulement (171) dont les bornes sont reliées aux plots d'alimentation dudit coupleur (21 et 22) et un second et troisième enroulements (172 et 173) reliés en série entre eux avec un point commun relié à une masse mécanique et les bornes libres respectives reliées à la borne commune des enroulements (32 et 33) du transformateur d'émission (30) et à la borne commune des enroulements (52 et 53) du transformateur de réception (50).

2. Coupleur électrique selon la revendication 1, **caractérisé en ce qu'**il comporte en outre un transformateur d'isolement (180) constitué de deux enroulements identiques couplés magnétiquement, dont les bornes d'entrée sont respectivement reliées aux bornes dudit premier enroulement (171) du transformateur d'isolation galvanique (170) et dont les bornes de sortie sont respectivement reliées aux plots d'alimentation (21 et 22) dudit coupleur électrique.

3. Coupleur électrique selon la revendication 2, **caractérisé en ce qu'**il comporte des capacités respectivement reliées en parallèle aux bornes des enroulements dudit transformateur d'isolement (180) formant, avec lesdits enroulements, des filtres réjecteurs à une fréquence correspondant à la ou une fréquence de résonnance des transformateurs d'émission et réception (30 et 50).

4. Coupleur électrique selon une des revendications précédentes, **caractérisé en ce que** le transformateur d'émission (30) comporte un quatrième enroulement (34) dont les bornes sont respectivement reliées aux premières bornes de deux enroulements identiques (71 et 72) dont les secondes bornes sont reliées à une masse mécanique, et le transformateur de réception (50) comporte un quatrième enroulement (54) dont les bornes sont respectivement reliées aux premières bornes de deux enroulements identiques (91 et 92) dont les secondes bornes sont reliées à la masse mécanique.

5. Coupleur électrique selon une des revendications précédentes, **caractérisé en ce qu'**il comporte un transformateur d'isolement (140) constitué de deux enroulements identiques couplés magnétiquement, dont les bornes d'entrée sont destinées à être reliées à la paire de fils (T) et dont les bornes de sortie sont respectivement reliées aux bornes des deux enroulements (32 et 33) du transformateur d'émission (30) qui sont reliés entre eux avec un point commun et un transformateur d'isolement (150) constitué de deux enroulements identiques couplés magnétiquement, dont les bornes d'entrée sont destinées à être reliées à la paire de fils (R) et dont les bornes de sortie sont respectivement reliées aux bornes des enroulements (52 et 53) du transformateur de réception (50).

6. Réseau de transport de données et d'alimentation prévu pour coupler, via un bus (B) constitué de deux paires de fils (T et R), des actionneurs électriques à des périphériques et à des alimentations de puissance, **caractérisé en ce qu'**il comporte au moins deux coupleurs électriques selon une des revendications 1 à 5.

## Patentansprüche

1. Elektrischer Leistungs-/Datenkoppler (20T; 20R), der aufweist:
- einen Sendetransformator (30), der aus einer Wicklung (31), um Datensignale zu empfangen, und aus zwei miteinander in Reihe geschalteten Wicklungen (32 und 33) mit einem gemeinsamen Punkt und zwei Klemmen besteht, die dazu bestimmt sind, mit einem ersten Paar von Drähten (T) einer Busleitung (B) verbunden zu werden, um an das Paar von Drähten (T) im Gegentaktbetrieb die an den Klemmen der ersten Wicklung (31) vorhandenen Datensignale zu liefern,
- einen Empfangstransformator (50), der aus zwei miteinander in Reihe geschalteten Wicklungen (52 und 53) mit einem gemeinsamen Punkt und zwei Klemmen, die dazu bestimmt sind, mit einem zweiten Paar von Drähten (R) der Busleitung (B) verbunden zu werden, um im Gegentaktbetrieb auf dem Paar von Drähten (R) der Busleitung(B) vorhandene Datensignale zu empfangen, und einer Wicklung (51) besteht, um die Datensignale zu liefern, und
- einen galvanischen Trenntransformator,
**dadurch gekennzeichnet, dass** der galvanische Trenntransformator (170) eine erste Wicklung (171), deren Klemmen mit den Versorgungsanschlüssen des Kopplers (21 und 22) verbunden sind, und eine zweite und dritte miteinander in Reihe geschaltete Wicklungen (172 und 173) mit einem mit einer mechanischen Masse verbundenen gemeinsamen Punkt und den jeweiligen freien Klemmen mit der gemeinsamen Klemme der Wicklungen (32 und 33) des Sendetransformators (30) und mit der gemeinsamen Klemme der Wicklungen (52 und 53) des Empfangstransformators (50) verbunden aufweist.

2. Elektrischer Koppler nach Anspruch 1, **dadurch gekennzeichnet, dass** er außerdem einen Trenntransformator (180) aufweist, der aus zwei magnetisch gekoppelten gleichen Wicklungen besteht, deren Eingangsklemmen je mit den Klemmen der ersten Wicklung (171) des galvanischen Trenntransformators (170) verbunden sind und deren Ausgangsklemmen je mit den Versorgungsanschlüssen (21 und 22) des elektrischen Kopplers verbunden sind.

3. Elektrischer Koppler nach Anspruch 2, **dadurch gekennzeichnet, dass** er Kondensatoren aufweist, die je mit den Klemmen der Wicklungen des Trenntransformators (180) parallelgeschaltet sind, der mit den Wicklungen Bandsperrfilter bei einer Frequenz bildet, die der oder einer Resonanzfrequenz der Empfangs- und Sendetransformatoren (30 und 50) entspricht.

4. Elektrischer Koppler nach einem der vorhergehenden Ansprüche, **dadurch gekennzeichnet, dass** der Sendetransformator (30) eine vierte Wicklung (34) aufweist, deren Klemmen je mit den ersten Klemmen von zwei gleichen Wicklungen (71 und 72) verbunden sind, deren zweite Klemmen mit einer mechanischen Masse verbunden sind, und der Empfangstransformator (50) eine vierte Wicklung (54) aufweist, deren Klemmen je mit den ersten Klemmen von zwei gleichen Wicklungen (91 und 92) verbunden sind, deren zweite Klemmen mit der mechanischen Masse verbunden sind.

5. Elektrischer Koppler nach einem der vorhergehenden Ansprüche, **dadurch gekennzeichnet, dass** er einen Trenntransformator (140), der aus zwei magnetisch gekoppelten gleichen Wicklungen besteht, deren Eingangsklemmen dazu bestimmt sind, mit dem Paar von Drähten (T) verbunden zu werden, und deren Ausgangsklemmen je mit den Klemmen der zwei Wicklungen (32 und 33) des Sendetransformators (30) verbunden sind, die miteinander verbunden sind mit einem gemeinsamen Punkt, und einen Trenntransformator (150) aufweist, der aus zwei magnetisch gekoppelten gleichen Wicklungen besteht, deren Eingangsklemmen dazu bestimmt sind, mit dem Paar von Drähten (R) verbunden zu werden, und deren Ausgangsklemmen je mit den Klemmen der Wicklungen (52 und 53) des Empfangstransformators (50) verbunden sind.

6. Datentransport- und Versorgungsnetz, das vorgesehen ist, um über eine Busleitung (B) bestehend aus zwei Paaren von Drähten (T und R) elektrische Stellglieder mit Peripheriegeräten und mit Leistungsversorgungen zu koppeln, **dadurch gekennzeichnet, dass** es mindestens zwei elektrische Koppler nach einem der Ansprüche 1 bis 5 aufweist.

## Claims

1. Power/data electrical coupler (20T; 20R) comprising:
- a sending transformer (30) consisting of a winding (31) for receiving data signals and two windings (32 and 33) connected in series with each other with a common point and two terminals intended to be connected to a first pair of wires (T) of a bus (B) in order to deliver to said pair of wires (T), in differential mode, the data signals present at the terminals of the first winding (31),
- a receiving transformer (50) consisting of two windings (52 and 53) connected in series with each other with a common point and two terminals intended to be connected to a second pair of wires (R) of said bus (B) in order to receive, in differential mode, data signals present on the pair of wires (R) of the bus (B) and a winding (51) for delivering said data signals, and
- a galvanic isolation transformer,
**characterised in that** said galvanic isolation transformer (170) comprises a first winding (171) the terminals of which are connected to the power supply pins of said coupler (21 and 22) and second and third windings (172 and 173) connected in series with each other with a common point connected to a mechanical ground and the respective free terminals connected to the common terminal of the windings (32 and 33) of the sending transformer (30) and to the common terminal of the windings (52 and 53) of the receiving transformer (50).

2. Electrical coupler according to claim 1, **characterised in that** it further comprises an isolation transformer (180) consisting of two identical windings coupled magnetically, the input terminals of which are respectively connected to the terminals of the winding (171) of the galvanic isolation transformer (170) and the output terminals of which are respectively connected to the supply pins (21 and 22) of said electrical coupler.

3. Electrical coupler according to claim 2, **characterised in that** it comprises capacitors respectively connected in parallel to the terminals of the windings of said isolation transformer (180) forming, with said windings, rejection filters at a frequency corresponding to the or one resonant frequency of the sending and receiving transformers (30 and 50).

4. Electrical coupler according to any of the preceding claims, **characterised in that** the sending transformer (30) comprises a fourth winding (34), the terminals of which are respectively connected to the first terminals of two identical windings (71 and 72), the second terminals of which are connected to a mechanical ground, and the receiving transformer (50) comprises a fourth winding (54), the terminals of which are respectively connected to the first terminals of two identical windings (91 and 92), the second terminals of which are connected to the mechanical ground.

5. Electrical coupler according to any of the preceding claims, **characterised in that** it comprises an isolation transformer (140) consisting of two identical magnetically coupled windings, the input terminals of which are intended to be connected to the pair of wires (T) and the output terminals of which are respectively connected to the terminals of the windings (32 and 33) of the sending transformer (30) and an isolation transformer (150) consisting of two identical magnetically coupled windings, the input terminals of which are intended to be connected to the pair of wires (R) and the output terminals of which are respectively connected to the terminals of the windings (52 and 53) of the reception transformer (50).

6. Data and power supply transport network provided for coupling electrical actuators, via a bus (B) consisting of two pairs of wires (T and R), to peripherals and power supplies, **characterised in that** it comprises at least two electrical couplers according to any of claims 1 to 5.
